# EUROPÄISCHE PATENTSCHRIFT

(11) **EP 0 612 074 B1**
(45) Veröffentlichungstag und Bekanntmachung des Hinweises auf die Patenterteilung: **02.05.2001**
(21) Anmeldenummer: 93102667.8
(22) Anmeldetag: 19.02.1993
(51) Int. Cl.: G11C 5/00, G06F 11/20

(54) **Spalten-Redundanz-Schaltungsanordnung für einen Speicher**
Column redundancy device for a memory
Dispositif de colonnes redondantes pour une mémoire

(43) Veröffentlichungstag der Anmeldung: 24.08.1994
(73) Patentinhaber: Infineon Technologies AG, 81669 München (DE)
(72) Erfinder: Savignac, Dominique Dr., W-85737 Ismaning (DE); Sommer, Diether, Dipl.-Phys., W-80469 München 5 (DE); Weidenhöfer, Jürgen, Dipl.-Ing., W-80799 München (DE)
(74) Vertreter: Zedlitz, Peter, Dipl.-Inf.

(56) Entgegenhaltungen:
- EP-A- 0 472 209
- EP-A- 0 492 099
- EP-A- 0 529 330

## Beschreibung

Die Erfindung betrifft eine Spalten-Redundanz-Schaltungsanordnung für einen Speicher gemäß dem Oberbegriff des Anspruchs 1.

Eine derartige Anordnung ist z.B. aus IEEE Journal of Solid State Circuits, Vol. 26, No. 1, Januar 1991 auf Seite 12ff beschrieben. Auch EP-A-0 472 209 stellt eine derartige Anordnung dar.

Die Verkleinerung der Rastermaße bei jeder neuen Speichergeneration erhöht die Anfälligkeit für Defekte im Zellenfeld. Eine rentable Produktion erfordert daher Vorrichtungen auf dem Speicher, mit denen solche Defekte repariert werden können. In der Regel sind Zusatz-Zellen vorgesehen, die mittels programmierbarer Codierungselemente anstelle der defekten Zellen eingesetzt werden.

Bei Speichern größerer Kapazität sind die Speicherzellen in mehrere Blöcke unterteilt. Wegen der matrixförmigen Anordnung der Speicherzellen, müssen die Zusatz-Zellen ebenfalls in Zeilen und Spalten angeordnet werden. Diese redundanten Leitungen sind im allgemeinen am Rande der Zellenfelder ausgebildet. Sie werden jeweils durch ein programmierbares Element im Zusammenhang mit den angelegten Adressen selektiert.

Diese programmierbaren Elemente können z.B. lasertrennbare Fuseblöcke sein. Üblicherweise wird jeder Fuseblock einer oder mehreren redundanten Leitungen fest zugeordnet. Soll die Reparaturfähigkeit gesteigert werden, muß die Anzahl der redundanten Leitungen erhöht und damit auch die Anzahl der Fuseblöcke vergrößert werden. Der Platzbedarf einer solchen Redundanz-Vergrößerung ist wesentlich und kann zu einer Verringerung der Stückzahl pro Scheibe führen. Bei den derzeitigen Speichergenerationen ist die benötigte Fläche für die Fuseblöcke zusammen mit deren Ansteuerschaltungen in etwa so groß wie die Fläche, welche die redundanten Speicherzellen in Anspruch nehmen. Einerseits zeigt eine Statistik der Redundanz-Ausnutzung, z.B. bei einem 4-Mega-Speicher, daß im Mittel nur die Hälfte der Fuseblöcke zur Reparatur eingesetzt werden. Andererseits hat sich bei der Defektanalyse herausgestellt, daß eine Verdoppelung der Redundanz bis zu 20 % mehr Ausbeute ermöglicht. Dies zeigt, daß bei der bisherigen Auslegung der Redundanzarchitektur, ein wesentlicher Anteil von Speichern nicht repariert werden kann, obwohl im Prinzip genügend programmierbare Codierungselemente zur Verfügung stehen.

Soll die Reparaturfähigkeit erhöht werden, so wäre es aus Platzgründen von Vorteil, wenn nur die Anzahl der redundanten Leitungen vergrößert werden müßte und mittels geeigneter Schaltung eine bessere Ausnutzung der vorhandenen Fuseblöcke erreicht werden könnte.

Bei einer Erweiterung der Spaltenredundanz stellt der Anstieg des Stromverbrauchs ein weiteres Problem dar. Im Gegensatz zur Ansteuerung der Reihenredundanz, die nur am Anfang eines Zyklus eingesetzt wird, muß die Ansteuerung der Spaltenredundanz im gesamten aktiven Zyklus betriebsbereit sein. Da für diese Ansteuerung bisher Schaltungen mit dynamischer Logik und Querstromanteilen verwendet worden sind, bedeutet die Erweiterung der Spaltenredundanz gleichzeitig auch einen Anstieg des Stromverbrauchs.

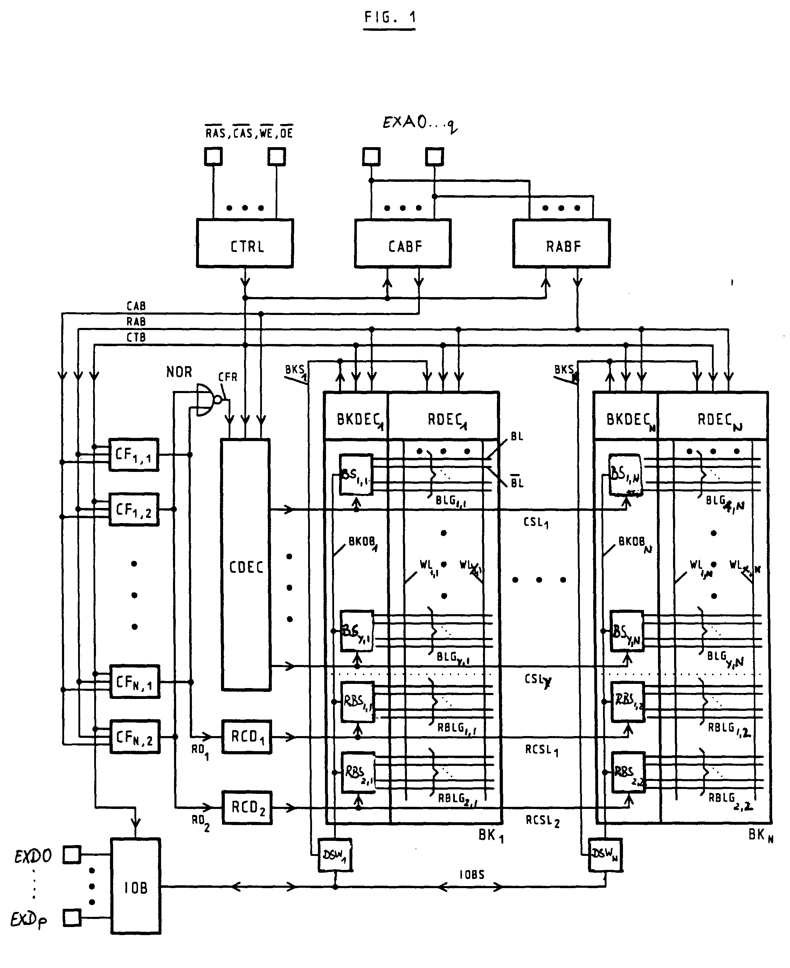

Ein vereinfachtes Blockschaltbild eines Speichers mit Spaltenredundanz, gemäß dem Stand der Technik ist in Figur 1 dargestellt. Dabei sind die Codiereinheiten für die redundanten Spalten blockfest zugeordnet. Figur 1 zeigt eine Kontrolleinheit CTRL, die die externen anliegenden Steuertakte RAS (Row-Address-Strobe),CAS (Column-Address-Strobe), WE (Write Enable) und gegebenenfalls OE (Output Enable) verarbeitet. In dieser Kontrolleinheit CTRL werden die üblichen internen Steuertakte erzeugt, die auf der Abbildung schematisch in einem Steuerbus CTB zusammengefaßt sind. Weiterhin ist eine Reihen-Adreß-Buffer-Einheit RABF dargestellt, die aus den externen Adressen EXAO...q interne Reihen-Adressen RAB unter der Kontrolle von Steuerleitungen aus der Einheit CTRL ableitet. Weiterhin ist eine Spalten-Adreß-Buffer-Einheit CABF dargestellt, die aus den externen Adressen EXAO...q zusammen mit Steuerleitungen aus der Kontrolleinheit CTRL interne Spaltenadressen CAB generiert. Eine Input-Output-Einheit IOB ist vorgesehen, die für den Datentransfer in und aus dem Speicher sorgt. An ihr sind externe Datenleitungen EXDO...p angeschlossen.

Diese Einheiten bilden die Standard-Peripherie des Speichers und werden deswegen nicht näher beschrieben. Die Funktion verschiedener Steuerleitungen wird nur in späteren Abschnitten erläutert, bei denen dies zum Verständnis einzelner Schaltungen notwendig ist.

Ferner sind in Figur 1 eine Gruppe von N Speicherblöcken BK_{1...N} gezeigt, wobei N ein Vielfaches von 2 ist, z.B. N=2^{m}, und von denen zwei, BK₁ und BKₙ in Figur 1 dargestellt sind. Weiterhin ist ein für alle Blöcke BKₙ (n=1...N) gemeinsamer Spaltendekoder CDEC dargestellt und, ohne allgemeine Beschränkung, zwei für alle Blöcke BK_{1...N} gemeinsame redundante Spaltendekoder RCD₁ und RCD₂. Schließlich sind zwei Gruppen von je N Codierungselementen CF_{1...N,1...2} für die Adreßcodierung und Spaltenredundanz, die später beschrieben werden, dargestellt.

Die Verwendung von gemeinsamen Spaltendekodern CDEC ist bei Speichern höherer Kapazität aus Platzgründen geläufig. Bis auf die vier ersten Peripherie-Einheiten, die nur einmal auf dem Speicher vorkommen, können selbstverständlich die restlichen Bestandteile mehrmals parallel aufgebaut werden. Figur 1 zeigt nur aus Gründen der Übersichtlichkeit eine einzige Gruppe von Speicherblöcken BK_{1...N}.

Ein Speicherblock BKₙ besteht aus einem Zellenfeld mit bekannter matrixförmiger Anordnung von Speicherzellen, Wortleitungen WL_{1,n}...WL_{x,n} und Bitleitungspaaren BLG_{1,n}...BLG_{y,n}, wobei hier z.B.eine "Folded-Bitlines"-Anordnung BL,/BL gezeigt ist, aus einem Blockdekoder BKDEC und einem Wort-Dekoder/Treiber RDEC_{1...n}, ferner aus Bit-Verstärkern/Schaltern BS_{1,n}BS_{y,n} und schließlich aus Datenbit-Verstärkern/Schaltern DSW_{1...n} (1≤n≤N).

Bei der gezeigten Darstellung ist jeweils nur ein einziger Speicherblock durch seinen zugehörigen Blockdekoder BKDECₙ aktiviert. Zu diesem Zweck wird ein erster Teil der Reihenadressen RAB den Blockdekodern BKDECₙ zugeführt. Diese Adressen sind so zahlreich, daß eine 1 aus N Auswahl getroffen werden kann. Die Blockauswahlleitung BKSₙ eines selektierten Blockdekoders BKDECₙ aktiviert den zugehörigen Wort-Dekoder/Treiber RDECₙ und die Datenbit-Verstärker/Schalter DSWₙ. Die Wortleitungen eines Speicherblocks BKₙ werden durch den aktiven Wort-Dekoder/Treiber RDECₙ selektiert, dem zu diesem Zweck der zweite Teil der Reihenadressen zugeführt wird. Redundante Wortleitungen sind hier nicht gezeigt.

Die Signale der Bitleitungspaare BLG_{y,n} werden durch den aktivierten Bit-Verstärker DSWₙ verstärkt und gruppenweise mittels Bitschaltern BS_{y,n} auf den Blockdatenbus BKDBₙ der entsprechenden Breite geschaltet. Diese Bit-Schalter werden jeweils durch eine aktive Bitgruppen-Auswahl-Leitung CSL_{1...Y} aus dem gemeinsamen Spaltendekoder CDEC betrieben. Die Bitgruppenauswahlleitungen CSL_{1...Y} werden durch den Spaltendekoder CDEC selektiert, dem hierfür ein erster Teil der Spalten-Adressen zugeführt wird. Der andere Teil dieser Adressen wird für die Daten-Dekodierung bei dem Input-Output-Buffer 10B verwendet. Bei dem in Figur 1 gezeigten Beispiel sind Y Bitgruppen-Auswahl-Leitungen vorhanden, wobei 2^{k}=Y gilt. Es sind also K Spaltenadressen zur Dekodierung der Y Auswahl-Leitungen vorhanden. Die Auswahl-Leitungen haben nur in dem aktiven Block eine Wirkung. Der Spaltendekoder CDEC besitzt zusätzlich einen Steuereingang CFR. Wenn dieses Signal inaktiv ist, d.h. wenn es z.B. logisch "0" bei positiver Logik ist, werden sämtliche Auswahl-Leitungen deaktiviert.

Die Daten auf dem Blockdatenbus BKDBₙ werden bei einem Lesezyklus verstärkt und über die Datenbit-Schalter von DSWₙ auf den Input-Output-Bus IOBS geschaltet. Dieser Bus 10BS verbindet die Datenbit-Schalter DSWₙ mit dem Input-Output-Buffer 10B. Umgekehrt werden bei einem Schreib-Zyklus die Daten von dem Input-Output-Bus IOBS über diese Schalter auf dem Blockdatenbus BKDBₙ geschrieben und über die selektierten Bitschalter BS_{y,n} in den jeweiligen Zellen gespeichert.

Bei jeden Speicherblock der Figur 1 sind zusätzlich zwei redundante Bitleitungsgruppen RBLG_{1,1...2,2} mit ihren zugehörigen Bit-Verstärkern/Schaltern RBS_{1,1...2,2} gezeigt. Diese Bitschalter-Gruppen werden jeweils durch eine redundante Auswahlleitung RCSL₁ bzw. RCSL₂ aus den für alle Speicherblöcke BKₙ gemeinsamen redundanten Treibern RCD₁ bzw. RCD₂ aktiviert. Die Funktion einer redundanten Einheit ist identisch mit der einer normalen Einheit.

Schließlich sind in der Figur 1 noch zwei Gruppen von je N Codierungselementen CF_{1...N,1...2} dargestellt, d.h. ein Element pro Speicherblock BK_{nT} und pro redundanter Auswahlleitung RCSL₁ bzw. RCSL₂. Diese Codierungselemente CF_{n,1...2} erhalten als Eingang den ersten Teil der Reihen-adressen RAB, der für die Blockdekodierung 1 aus N zuständig ist und dieselben Spaltenadressen CAB wie der Spalten-dekoder CDEC. Ihre Ausgänge sind auf zwei getrennten Leitungen geschaltet; CF_{1...N,1} auf RD₁ bzw. CF_{1...N,2} auf RD₂. Diese Leitungen sind den Eingängen der redundanten Treiber RCD₁ bzw. RCD₂ und einem NOR-Gatter zugeführt. Der Ausgang des NOR-Gatters bildet den Eingang CFR des Spaltendekoders.

Bei jeden Zyklus wird ein Speicherblock, BKₙ über den entsprechenden Blockdekoder BKDECₙ aktiviert. Mit derselben Reihen-Adreß-Kombination werden auch die zwei zugehörigen Codierungselemente CF_{n,1} und CF_{n,2} selektiert. Im Normalfall sind die Leitungen RD₁ und RD₂ inaktiv z.B. logische "0". Dementsprechend sind auch die redundanten Ausfall-Leitungen RCSL₁ und RCSL₂ inaktiv, und das Steuersignal CFR, hier logisch "1" gibt dem Spaltendekoder CDEC frei. Eine den Spaltenadressen CAB entsprechende Ausfall-Leitung CSLi wird also selektiert und schaltet eine normale Bitleitungsgruppe BLG_{y,n} auf dem Blockdatenbus BKDBₙ des aktiven Speicherblocks BKₙ.

Wenn in dem gewählten Speicherblock BKₙ eine angesprochene Speicherzelle der Bitleitungsgruppe BLG_{y,n} defekt ist, wird eine der zwei Codierungselemente CF_{n,1} oder CF_{n,2} für die entsprechende Spaltenadresse programmiert. Beim Auftreten dieser Adresse wird die Leitung RD₁ oder RD₂ aktiviert. Im hier gezeigten Beispiel sind diese logisch "1". Demzufolge wird das Steuersignal CFR inaktiv, also logische "0", und sperrt den Spaltendekoder CDEC. Die im Normalfall selektierte Auswahlleitung CSL_{y} bleibt dadurch inaktiv stattdessen wird die redundante Leitung RCSL₁ oder RCSL₂ logisch "1". Dadurch werden die Speicherzellen der Bitleitungsgruppe RBLG₁ oder RBLG₂ anstelle denen der normalen Einheit angesprochen. Mit der gezeigten Auslegung der Spaltenredundanz können also pro Speicherblock zwei verschiedene Bitleitungsgruppen mit defekten Zellen durch redundante Gruppen ersetzt werden.

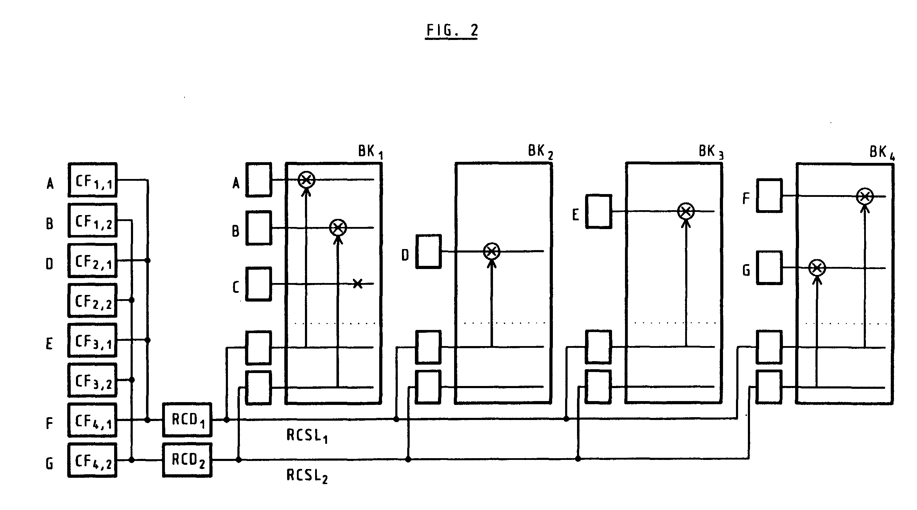

Figur 2 zeigt ein Reparaturbeispiel bei blockfester Spaltenredundanz gemäß Figur 1 für den Fall, daß N=4 und zwei redundante Bitleitungsgruppen pro Block vorhanden sind und daß 6 Fehler auftreten. Die fehlerhaften Einheiten sind mit den Buchstaben A-G gekennzeichnet. Im ersten Block treten drei Fehler auf A, B, C , im zweiten und dritten je ein Fehler D bzw. E und im letzten Block zwei F und G. Auf der linken Seite der Figur 2 ist die Ausnutzung der Codierungselemente CF1,1...CF4,2 gezeigt. Da pro Speicherblock BK1...4 nur jeweils zwei fehlerhafte Einheiten repariert werden können, ist klar, daß in diesem Beispiel der Speicher nicht repariert werden kann, obwohl zwei unbenutzte Dekodierungselemente übrig bleiben, da nur sechs der zur Verfügung stehenden acht Codierungselemente CF_{1,1...4,2} verwendet werden können. Fehlerhafte Stellen in den Speicherblöcken BK1...4 sind mit einem Kreuz gekennzeichnet. Die durch redundante Bitleitungsgruppen ersetzen fehlerhaften Einheiten sind mit einem Kreis gekennzeichnet.

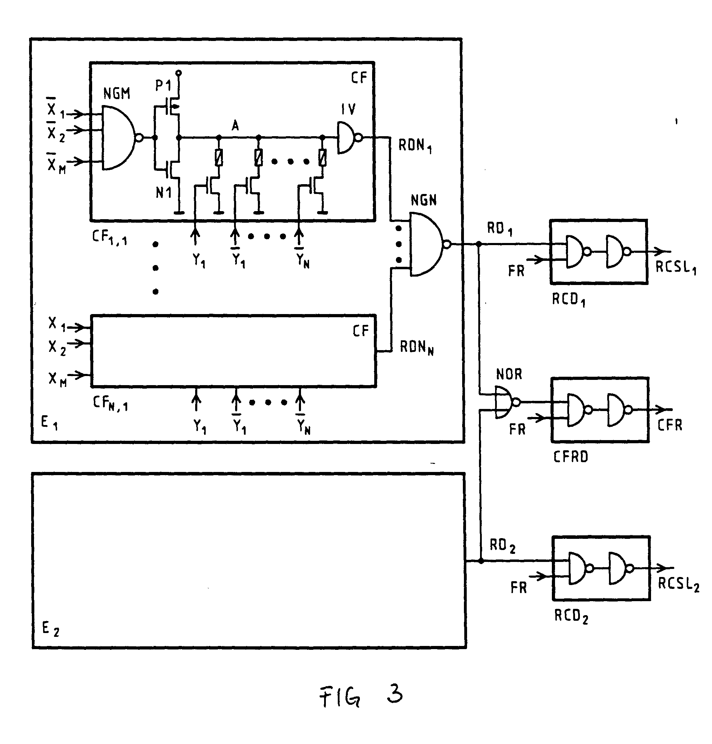

Als Codierungselemente werden zumeist sogenannte Fuseblöcke eingesetzt. Figur 3 zeigt eine übliche Schaltung gemäß dem Stand der Technik zur Codierung der Spaltenadressen bei der blockfesten Spalten-Redundanz für den Fall, daß bei der Schaltungsanordnung gemäß Figur 1 lasertrennbare Fuseblöcke als Codierungselemente verwendet werden. Die zwei obengenannten Gruppen von Codierungselementen sind identisch aufgebaut und als Einheit E₁ bzw. E₂ dargestellt, wobei nur eine ausführlich gezeigt wird. Eine solche Einheit E₁ besteht aus N identischen Schaltungen CF_{1...N,1} bei E₁ bzw. CF_{1...N,2} bei E₂ und aus einem NAND-Gatter NGN mit N Eingängen RDN_{1...N} und einem Ausgang RD₁ bei E₁ bzw. RD₂ bei E₂. Die zwei Ausgangssignale RD₁ und RD₂ sind je einem redundanten Treiber RCD₁ bzw. RCD₂ mit den Ausgängen RCSL₁ bzw. RCSL₂ und dem in Figur 2 schon dargestellten Gatter NOR zugeführt. Der Ausgang dieses Gatters NOR ist an einen Treiber CFRD angeschlossen, dessen Ausgang das Signal CFR ist. Diese drei Treiber bestehen aus einem NAND-Gatter und einem nachgeschalteten Inverter. Der zweite Eingang dieser NAND-Gatter ist an einem Freigabesignal FR angeschlossen, das bei einem Zustand logisch "0" sowohl die normalen als auch die redundanten Auswahlleitungen auf niedrigem Potential logisch "0" hält. Dieses Freigabesignal FR wird üblicherweise für Synchronisationszwecke verwendet.
Jede Schaltung CF_{i,j} besitzt ferner M Eingänge für die Blockcodierung, dabei gilt N=2^{M}, 2 x K Eingänge für die Spaltenkodierung, dabei gilt Y=2^{k}, und einen Ausgang RDNᵢ, der mit einem Eingang des NAND-Gatters NGN verbunden ist.

Eine solche Schaltung CF_{i,j} besteht aus einem NAND-Gatter NGN mit M Eingängen, aus einem nachgeschalteten Inverter P1, N1, aus 2 x K N-Kanal-Transistoren in Serie mit je einem Fuseelement, die am Ausgang A des Inverters P1, N1 parallel geschaltet und aus einem Ausgangsinverter IV. Die Blockauswahl geschieht über das Eingangs-NAND-Gatter NGN, dem z.B. eine von allen möglichen Kombinationen von M Leitungen aus dem M Block-Adreß-Leitungen X_{1...M} und ihren komplementären Leitungen/X_{1...M} zugeführt wird. Eine Schaltung CF_{i,j} wird dann aktiviert, wenn alle Eingänge dieses NAND-Gatters logisch "1" sind. Sein Ausgang ist dann logisch "0" und der Ausgang A des Inverters P1, N1 demzufolge logisch "Eins". Bei allen anderen Schaltungen CF ist mindestens ein Eingang Xₘ bzw./Xₘ logisch "0". Die Inverterausgänge A sind demnach auch logisch "0" und die Leitungen RDNₙ logisch "1".

Wenn Y=2^{k} Auswahlleitungen CSL_{1...Y} vorhanden sind, werden 2 x K Spalten-Adreß-Leitungen für die Codierung einer Spaltenadresse benötigt, ohne allgemeine Beschränkung z.B. Y_{1...K} bzw./Y_{1...K}, weil die Serienschaltung eines n-Kanal-Transistors und eines lasertrennbaren Fuse-Elements nur bei einem Eingangssignal mit Zustand logisch "1" eine Wirkung zeigt.

Wenn bei der aktivierten Schaltung CF_{i,j} mindestens ein Fuse-Element, bei dem die entsprechende Spalten-Adreß-Leitung den Zustand logisch "1" hat, nicht getrennt ist, wird der Knoten A über diesen eingeschalteten N-Kanal-Transistor auf so niedrigem Potential gehalten, daß der Ausgangsinverter IV auf logisch "1" schaltet. In diesem Fall haben demnach alle Leitungen RDN_{1...N} den Zustand logisch "1" und die Ausgangsleitung RDJ von NGN den Zustand logisch "0". Die zugeordnete redundante Auswahlleitung RCSLⱼ ist also unabhängig vom Signal FR inaktiv, d.h. logisch "0". Trifft dies für beide Leitungen RD₁ und RD₂ zu, sind auf beide redundanten Leitungen RCSL₁ und RCSL₂ inaktiv und der Ausgang des Gatters NOR logisch "1". Wenn das Freigabesignal FR aktiv "1" wird, nimmt das Signal CFR ebenfalls den Zustand logisch "1" an, und entriegelt den Spaltendekoder. In diesem Falle wird eine normale Bitleitungsgruppe selektiert.

Wenn im Gegenteil bei einer aktiven Schaltung CF_{i,1} oder CF_{i,2} alle Fuseelemente getrennt sind, bei denen die entsprechenden Spalten-Adreß-Leitungen logisch "1" sind, bleibt der Knoten A auf hohem Potential geladen und der Ausgangsinverter IV im Zustand logisch "Null". Demzufolge nimmt eine Leitung RD₁ oder RD₂ den Zustand logisch "1" an. Der Ausgang des Gatters NOR ist also logisch "0". Dies gilt ebenfalls für das Signal CFR unabhängig vom Freigabe-signal FR, so daß der Spaltendekoder verriegelt wird. Dagegen wird die redundante Auswahlleitung RCSL₁ oder RCSL₂ aktiviert und die entsprechende redundante Bitleitungsgruppe im aktiven Speicherblock BKᵢ selektiert.

EP 0 492 099 stellt auch eine solche Schaltung dar.

Ein Nachteil der beschriebenen Lösung ist, daß beim Anlegen einer nichtprogrammierten Spalten-Adresse, d.h. in Y-1 Fällen von Y, im gesamten aktiven Zyklus ein Querstrom über den Transistor P1 der selektierten Schaltung CF_{i,j} nach dem niedrigen Potential fließt. Dieser Querstrom tritt evtl. zweimal bei jeder Speicherblockgruppe E₁, E₂ auf und nimmt bei konkreten Lösungen mit mehreren solchen Gruppen einen unzulässig hohen Wert an. Ein weiterer Nachteil ist, ebenfalls in konkreten Fällen, die zu hohe Zahl von Leitungen RDN_{1...N} und das dadurch bedingte ungünstig große Ausgangsgatter NGN.

Aufgabe der vorliegenden Erfindung ist es, eine verbesserte Ausnutzung der vorhandenen Fuseblöcke bei der Vergrößerung der Spalten-Redundanz und eine Reduktion des Stromverbrauchs zu ermöglichen.

Diese Aufgabe wird durch den kennzeichnenden Teil des Anspruchs 1 gelöst. Weiterbildungen sind Kennzeichen der Unteransprüche.

Die Erfindung wird nachfolgend anhand von 11 Figuren näher erläutert.

Es zeigen:
- Figur 1: ein vereinfachtes Blockschaltbild eines Speichers mit Spalten-Redundanz gemäß dem Stand der Technik,
- Figur 2: ein Blockschaltbild, welches ein vereinfachtes Reparaturbeispiel bei blockfester Spaltenredundanz darstellt,
- Figur 3: eine Schaltungsanordnung für Fuseblöcke und ihre Ansteuerung bei blockfester Spalten-Redundanz gemäß dem Stand der Technik,
- Figur 4: ein vereinfachtes Blockschaltbild eines erfindungsgemäßen Speichers mit blockfreier Implementierung der Spaltenredundanz,
- Figur 5: ein Blockschaltbild welches ein vereinfachtes Reparaturbeispiel bei blockfreier Spaltenredundanz gemäß der vorliegenden Erfindung darstellt,
- Figur 6: eine Schaltungsanordnung der Fuseblöcke und ihre Ansteuerung bei blockfreier Spaltenredundanz gemäß der vorliegenden Erfindung,
- Figur 7: ein Zeitdiagramm der Signale von Figur 6,
- Figur 8: eine weitere Ausführungsform der Fuseblöcke und ihrer Ansteuerung bei blockfreier Spaltenredundanz,
- Figur 9: eine Zeitdiagramm der Signale von Figur 8,
- Figur 10: eine Schaltungsanordnung zur Erzeugung des Setzpulses SP gemäß Figur 6 und
- Figur 11: eine Schaltungsanordnung zur Erzeugung des Signals XVLD gemäß Figur 8,
- Figur 12: ein Zeitdiagramm zur Erläuterung der Funktion der Schaltung gemäß Figur 10.

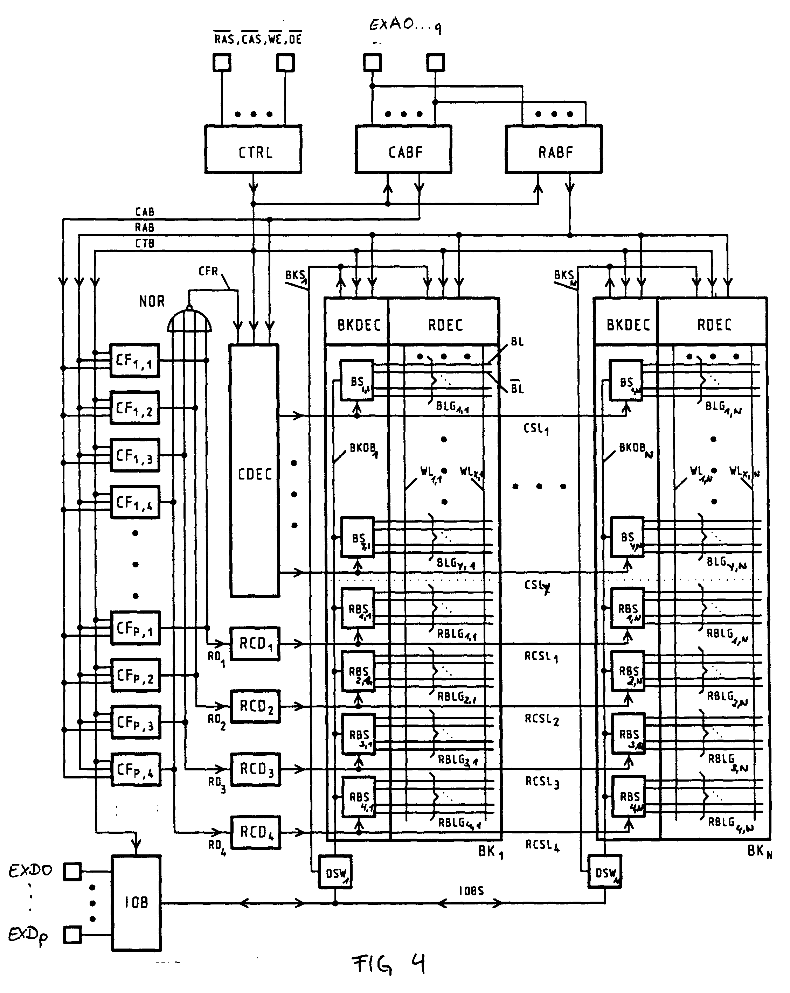

Figur 4 zeigt als Beispiel einer erfindungsgemäßen Implementierung der blockfreien Spaltenredundanz das vereinfachte Blockschaltbild eines Speichers mit derselben Grundorganisation wie bei der Figur 1. Im Unterschied zur vorherigen Lösung enthält jeder Speicherblock BK_{N} z.B. die doppelte Anzahl von redundanten Bitleitungsgruppen RBL-G_{1,n...4,n} und Bitverstärkern/Schaltern RBS_{1,n...4,n}. Dementsprechend werden die vier redundanten Auswahlleitungen RCSL_{1...4} von vier redundanten, für alle Speicherblöcke gemeinsamen Treibern RCD_{1...4} betrieben. Ferner wird dieselbe Anzahl von Codierungselementen CF_{1,1...P,4} wie vorhin verwendet, d.h. 2 x N, die aber in vier Gruppen von P=N:2 Elementen unterteilt sind, und bei denen zusätzlich die Speicherblockadresse programmiert werden kann. Die Codierungselemente erhalten als Eingang den ersten Teil der Reihenadressen RAB, der für die Blockdekodierung 1 aus N zuständig ist und dieselben Spaltenadressen CAB wie der Spaltendekoder CDEC. Ihre Ausgänge sind auf vier getrennten Leitungen RD_{1...4} geschaltet; CF_{1...P,j} auf RDⱼ, j=1..4. Diese Leitungen werden den Eingängen der redundanten Treiber RCD_{1...4} und einem vierfachen NOR-Gatter NOR zugeführt. Der Ausgang des NOR-Gatter NOR bildet den Eingang CFR des Spaltendekoders CDEC. Bei jedem Zyklus wird mit einer bestimmten Reihen-Adreß-Kombination ein Speicherblock BKₙ aktiviert. Im Normalfall sind die Leitungen RD_{1...4} inaktiv und dementsprechend auch die redundanten Ausfall-Leitungen RCSL_{1...4}. Das Steuersignal CFR ist also logisch "1" und aktiviert den Spaltendekoder CDEC. Wenn in dem Speicherblock BKₙ eine angesprochene Speicherzelle der Bitleitungsgruppe BLGy,n defekt ist, wird ein Codierungselement CF_{i,j} für die entsprechenden Block- und Spalten-adressen programmiert. Beim Auftreten dieser Blockadresse wird das hierfür programmierte Codierungselement CF_{i,j} selektiert und beim Anlegen der entsprechenden Spaltenadresse wird die Leitung RDⱼ aktiviert. Das hierdurch inaktive Steuersignal CFR sperrt den Spaltendekoder CDEC und die redundante Leitung RCSLⱼ wird anstelle der Auswahlleitung CSL_{y} betrieben.

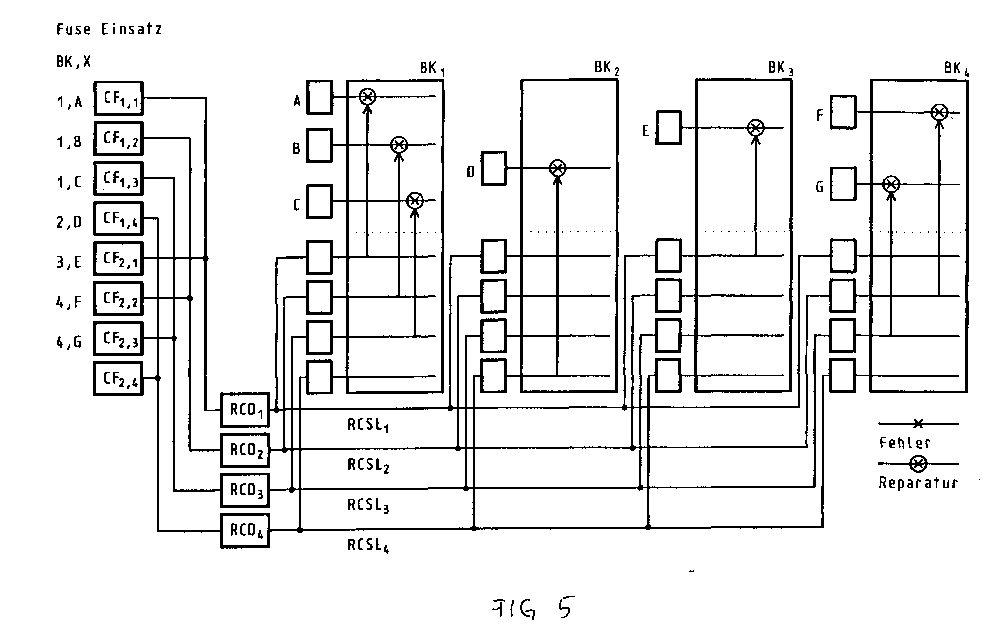

Die Gesamtzahl der möglichen Reparaturen bleibt wie bei der ersten Lösung 2 x N. Aber statt zwei fester definierter Codierungselemente CF_{i,j} stehen bei dieser neuen Lösung pro Speicherblock bis zu vier solcher Elemente CF_{i,1...4} für Reparaturzwecke zur Verfügung. Wie am Anfang schon erwähnt, wird dadurch eine bessere Ausnutzung erreicht. Der Platzbedarf für die redundanten Bitleitungsgruppen BLG_{y,n} ist genauso groß wie bei einer Verdoppelung der Spaltenredundanz der ersten Lösung. Da aber die Zahl der Speicherblöcke BKₙ im allgemeinen wesentlich kleiner ist, als die Zahl der Auswahlleitungen CSL_{y}, müssen bei den abgeänderten Codierungselementen CF_{i,j} nur wenige Zusatzadressen programmierbar sein. Deshalb ist ihr Platzbedarf wesentlich kleiner als bei der notwendigen Verdoppelung der Codierungselemente CF_{i,j} für die erste Lösung. Die Verwendung der beschriebenen blockfreien Spaltenredundanz ist in allen Fällen vorteilhaft, wenn aus Platzgründen eine Vergrößerung der konventionellen Redundanz nicht mehr möglich ist. Figur 5 zeigt ein Reparaturbeispiel bei blockfreier Spaltenredundanz für dieselbe Anordnung wie bei Figur 2. In diesem Falle kann der Speicher offensichtlich repariert werden. Gleiche Elemente der Figur 2 und Figur 5 haben die gleiche Bezeichnung. In der schematischen Darstellung gemäß Figur 5 sind im Unterschied zu Figur 2 erfindungsgemäß blockunabhängige Codierungselemente CF_{1,1...}CF_{2,4} und hier vier redundante Treiber RCD_{1...}RCD₄ vorgesehen. Defekte Speicherzellen sind wiederum symbolisch mit einem Kreuz gekennzeichnet und erfolgreich reparierte mit einem Kreis umrandet.

Figur 1 und Figur 4 zeigen jeweils eine Redundanzanordnung, bei der jedem aktiven Speicherblock BKₙ Codierungselemente CF_{i,j} zugeordnet werden können. Diesen Codierungselementen CF_{i,j} wird derselbe Blockadreßbus CAB, RAB, CTB zugeführt, der für die Speicherblockdekodierung zuständig ist. Ohne Veränderung des Grundgedankens der Erfindung sind jedoch auch solche Anordnung möglich, bei denen die Codierungselemente CF_{i,j} mehreren Speicherblöcken gleichzeitig zugeordnet werden. Diesen Codierungselementen wird dann nur eine Untergruppe der Blockadressen zugeführt. Das Ersetzen einer defekten Bitleitungsgruppe geschieht dabei in allen diesen Speicherblöcken gleichzeitig und unabhängig davon, in welchem Speicherblock sich ein Defekt tatsächlich befindet. Bei dieser Art von Redundanz-Architektur kann im Sinne der Erfindung ohne Beschränkung ein Speicherblock BKₙ als eine Gruppe von Q einzelnen Speicherblöcken BK_{n,1...Q} aufgefaßt werden.

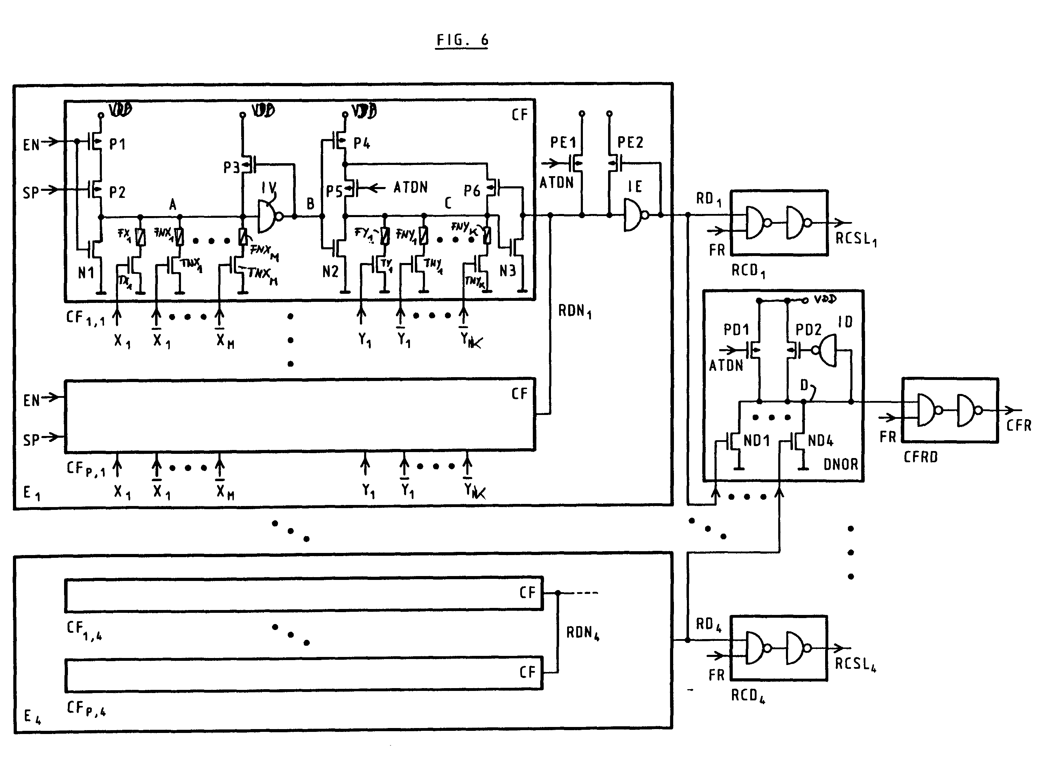

Figur 6 zeigt eine erfindungsgemäße Schaltung zur Codierung der Spalten-Adressen bei der blockfreien Spalten-Redundanz mit Fuseblöcken als Codierungselemente. Bei dieser Lösung sind die insgesamt 2 x N Codierungselemente in vier identisch Einheiten Ej, j=1..4 unterteilt. Eine solche Einheit besteht aus P=N/2 Kodierschaltungen CF_{i,j} (CF_{1..P,1..4} bei E_{1..4}, wobei N durch zwei teilbar sein soll), und aus einem Inverter IE zusammen mit zwei P-Kanal-Transistoren PE1 und PE2. Der Eingang des Inverters IE ist eine für alle P Schaltungen gemeinsame Leitung RDNj. Die Transistoren PE1 und PE2 sind zwischen dem hohen Potential (VDD) und dieser Leitung angeschlossen. PE1 ist ein Setz-Transistor mit Gate-Signal ATDN, dessen Funktion später erklärt wird, und PE2 ein Rückhalte-Transistor. Sein Gate ist am Inverter-Ausgang RDj (j=1..4) von IE angeschlossen. Die vier Ausgangssignale RD_{1..4} sind je einem redundanten Treiber RCD_{1..4} mit den Ausgängen RCSL_{1..4} und einem dynamischen NOR-Gatter DNOR zugeführt. Der Ausgang dieses Gatters DNOR ist an einem Treiber CFRD angeschlossen, dessen Ausgang das Signal CFR ist. Aufbau und Funktion dieser Treiber sind dieselben wie bei der Figur 3.

Die Schaltung DNOR besteht aus zwei zwischen dem hohen Potential VDD und einem Knoten D parallel geschalteten P-Kanal-Transistoren PD1 und PD2, aus vier zwischen dem Knoten D und dem niedrigen Potential VSS parallel geschalteten N-Kanal-Transistoren ND_{1..4}, und aus einem Inverter ID mit Eingangssignal D. Das Gate von PD1 ist an dem Signal ATDN angeschlossen. Der Ausgang von ID ist mit dem Gate von PD2 in einer Rückhaltekonfiguration verbunden. Die Gates der Transistoren ND_{1..4} sind an den Leitungen RD_{1..4} angeschlossen.

Jede Schaltung CF besitzt ferner 2xM Eingänge für die Blockkodierung (N=2^{M}), 2xK Eingänge für die Spaltenkodierung (L=2^{K}), zwei Steuer-Eingänge EN und SP, sowie den schon erwähnten gemeinsamen Ausgang RDNⱼ. Eine solche Schaltung besteht aus zwei in Serie geschalteten P-Kanal-Transistoren P1 und P2, und aus einem N-Kanal-Transistor N1. An den Gates von P1 und N1 ist das Enable-Signal EN und an dem Gate von P2 das Setzsignal SP angeschlossen. Der gemeinsame Anschluß A zwischen P2 und N1 ist der Eingang eines Inverters IV mit P-Kanal-Transistor P3 in Rückhalte-Konfiguration. An dem Knoten A sind ferner 2xM N-Kanal-Transistoren TX_{1...M},TNX_{1...M} in Serie mit je einem Fuseelement FX_{1...n},FNX_{1...M} parallel geschaltet. Die Gates dieser Transistoren sind mit den Reihen-Adressen X_{1..M} bzw./X_{1..M} verbunden. Der Ausgang B des Inverters IV ist an den Gates des P-Kanal-Transistors P4 und des N-Kanal-Transistors N2 angeschlossen. Zwischen diesen Transistoren liegt ein weiterer P-Kanal-Transistor P5 mit Gatesignal ATDN. Der gemeinsame Anschluß C zwischen N2 und P5 ist der Eingang eines "Pull-Down"-N-Kanal-Transistors N3, dessen Drain-Ausgang mit der gemeinsamen Leitung RDNⱼ verbunden ist. Ein letzter P-Kanal-Transistor P6 ist am gemeinsamen Anschluß zwischen P4 und P5 und am Anschluß C geschaltet. Sein Gate ist an der Ausgangsleitung RDNⱼ in einer Rückhalte-Konfiguration geschaltet. Schließlich sind am Anschluß C 2xK N-Kanal-Transistoren TY_{1...K}, TNY_{1...K} in Serie mit je einem Fuseelement FY_{1...K}, FNY_{1...K} parallel geschaltet. Die Gates dieser Transistoren sind mit den Spalten-Adressen Y_{1..K} bzw./Y_{1..K} verbunden.

An diesem Punkt soll betont werden, daß weder die Verwendung der Block-Adressen noch der Spalten-Adressen der hier gezeigten Art der Dekodierung mit komplementären Adreßleitungen eine Einschränkung bedeutet. Stattdessen können auch sogenannte predekodierte Adreß-Leitungen benutzt werden, bei denen z.B. jeweils eine Leitung von vieren aktiv ist.

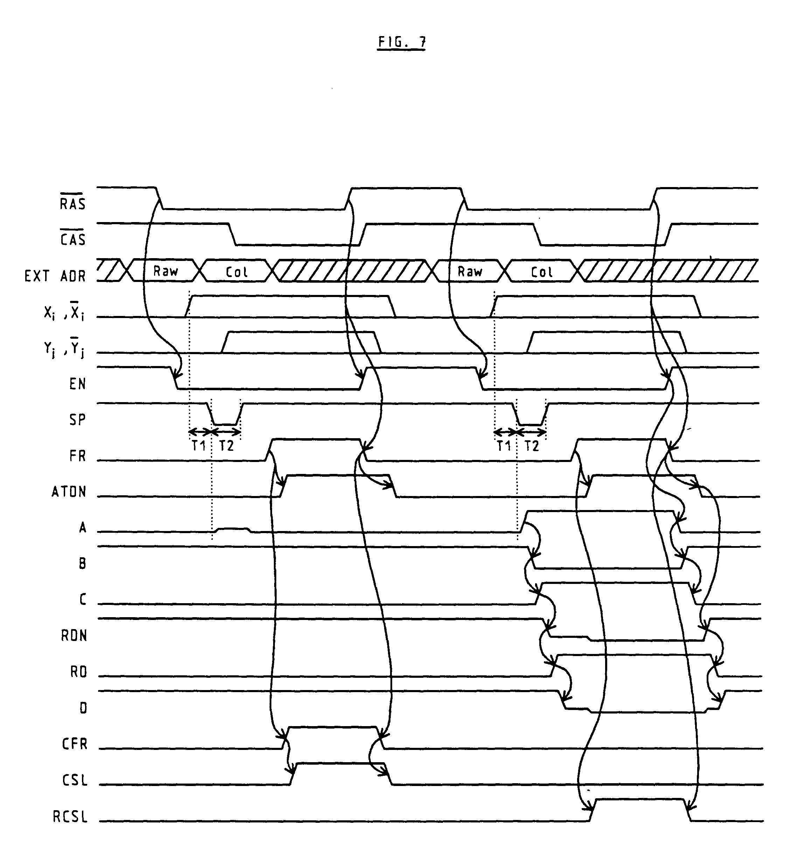

Die Funktion der beschriebenen Schaltung wird anhand des Zeitdiagramms vom Figur 7 erklärt, wobei nur die notwendigen Speichersignale dargestellt sind. Der erste Teil zeigt einen Zyklus ohne Einsatz der Spalten-Redundanz, während der zweite Teil die Aktivierung dieser Redundanz darstellt.

In der Ruhe-Phase (/RAS="1" / CAS="1") sind die Block-adressen X_{1..M} und /X_{1..M}, das Freigabe-Signal FR und das Steuersignal ATDN im Zustand logisch "0", während das Enable-Signal EN und das Setz-Signal SP im Zustand log. "1" sind. Mit dem Signal EN auf hohem Potential sind bei allen Schaltungen CF_{i,j} die Signale A log. "0", B log. "1" und C log. "0". Demzufolge sperren alle N-Kanal-Transistoren N3. Mit dem Steuersignal ATDN auf niedrigem Potential sind alle P-Kanal-Transistoren PE1 im leitenden Zustand und folglich die Leitungen RDNⱼ log. "1", RDⱼ log. "0" und RCSLj log. "0". Da alle N-Kanal-Transistoren des Gatters DNOR im gesperrten Zustand sind, liegt der Knoten D mit ATDN="0" auf hohem Potential. Das Freigabesignal FR ist jedoch log. "0", so daß ebenfalls CFR auf niedrigem Potential liegt. Der Bitdekoder ist also verriegelt.

Ein Schreib- oder Lese-Zyklus wird durch die fallende Flanke des Signals /RAS eingeleitet, wobei die extern anliegenden Reihen-Adressen gespeichert werden. Kurz danach wird eine bestimmte Kombination von M Leitungen aus den 2xM Block-Adreß-Leitungen Xᵢ und /Xᵢ aktiv log. "1". Das Enable-Signal EN, das auch anderweitig auf dem Speicher Anwendung findet, wird log. "0". In allen Schaltungen CF_{i,j} wird der Transistor P1 dadurch leitend. Der Transistor N1 dagegen wird gesperrt. Mit einer kleinen Verzögerung T1, nachdem alle aktiven Block-Adreß-Leitungen einen stabilen logischen Zustand eingenommen haben, wird das Setzsignal SP für die Dauer T2 (einige Nanosekunden) log. "0". Während dieser Zeit T2 sind beide Transistoren P1 und P2 leitend. Dadurch kan ein Ladestrom vom hohen Potential VDD zum Knoten A fließen. Wenn für eine Schaltung CF_{i,j} (erster Teil des Zeitdiagramms von Figur 7) mindestens bei einem N-Kanal-Transistor mit nicht abgetrennten Fuseelement die Blockadresse log. "1" ist, wird der Knoten A durch diese leitende Verbindung auf so niedrigem Potential gehalten, daß der Ausgang B des Inverters IV log. "1" bleibt. Dadurch ist C log. "0" und der N-Kanal-Transistor N3 gesperrt. Da auch P4 mit B="1" gesperrt ist, spielen die Transistoren P5 und P6 keine Rolle. In diesem Zustand ist die Schaltung CF_{i,j} also inaktiv.

Ein kleiner Querstrom fließt während der Zeitdauer T2 von hohem Potential VDD durch die Transistoren P1 und P2 und im schlimmsten Falle durch die Hälfte aller N-Kanal-Transistoren mit nicht abgetrennten Fuseelementen nach dem niedrigen Potential VSS. Dieser Strom, der bei vollkommen fehlerfreien Speichern bei allen Schaltungen CF_{i,j} vorkommt, kann jedoch durch die Dimensionierung der Transistoren P1 und P2 und durch eine minimale Zeitdauer T2 extrem gering gehalten werden. Dabei wird vor allem der Umstand ausgenützt, daß für DRAM-Speicher eine relativ lange Zeitspanne für die Blockdekodierung der Spalten-Redundanz zur Verfügung steht. Der Eingangsteil der Schaltung CF_{i,j}, der für diese Blockdekodierung zuständig ist, muß deshalb keine hohe Geschwindigkeit aufweisen.
Falls alle Schaltungen CF_{i,j} einer Einheit Eⱼ inaktiv sind, sperren alle Transistoren N3. Die Leitung RDNⱼ ist dann durch den eingeschalteten P-Kanal-Transistor PE1 (ATDN="0") log. "1" und die Ausgangs-Leitung RDj sowie die redundante Auswahl-Leitung RCSLⱼ folglich log. "0". Wenn, wie später erklärt wird, das Steuersignal ATDN auf hohes Potential steigt, wird der Zustand log. "1" der Leitung RDNⱼ durch den eingeschalteten Rückhalte-Transistoren PE2 mit Gate an log. "0" beibehalten. Haben alle Leitungen RDⱼ, wie im ersten Teil der Figur 7 angenommen ist, den Zustand log. "0", dann sind alle redundanten Auswahlleitungen RCSL_{1..4} inaktiv log. "0" und alle vier N-Kanal-Transistoren ND_{1..4} des Gatter DNOR gesperrt. Der Knoten D bleibt, auch mit ATDN im Zustand log. "1", durch den eingeschalteten P-Kanal-Rückhalte-Transistor PD2 log. "1".

Mit der steigenden Flanke des Freigabe-Signals FR wird folglich CFR log. "1" und der Spalten-Dekoder CDEC wird freigegeben. Mit der fallenden /CAS-Flanke werden die extern anliegenden Spalten-Adressen in der Einheit CABF gespeichert, die zuvor für diese Adressen transparent war. Eine normale Auswahlleitung CSL wird aktiv und die entsprechende Bitleitungsgruppe des gerade aktiven Speicherblocks selektiert.

Der erste Schreib- oder Lese-Zyklus von Figur 7 wird durch die steigende /RAS-Flanke beendet, welche das Signal EN auf hohem Potential und das Signal FR auf niedrigem Potential zurücksetzt. In der folgenden Ruhepause sind, wie bereits erklärt, alle Schaltungen CF_{i,j} und die redundanten Auswahlleitungen RCSL_{1..4} durch EN bzw. FR inaktiv. Der Bitdekoder ist mit CFR gleich log. "0" verriegelt.
Im zweiten Teil des Zeitdiagramms von Figur 7 ist ein Redundanz-Fall dargestellt. Der Anfang eines Schreib- oder Lese-Zyklus verläuft wie beim ersten Teil. Wenn für eine Schaltung CF_{i,j} in einer beliebigen Einheit Eⱼ alle Fuseelemente abgetrennt sind, bei denen die zugehörigen Block-adressen den Wert log. "1" annehmen, steigt der Knoten A wegen der eingeschalteten P-Kanal-Transistoren P1 und P2 auf hohes Potential. Der Ausgang B der Inverters IV wird log. "0" und schaltet den Rückhalte-Transistor P3 ein. Der Zustand log. "1" von A bleibt deshalb nach Ablauf von T2 (SP wieder log. "1") erhalten. In diesem Zustand ist die Schaltung CF_{i,j} selektiert. Selbstverständlich darf in jeder Einheit Eⱼ jeweils nur eine solche Schaltung aktiv sein. Die Transistoren P4 bzw. P5 sind durch B bzw. ATDN (beide log. "0") eingeschaltet, der Transistor N2 dagegen ausgeschaltet. Dadurch kann ein Ladestrom vom hohen Potential VDD zum Knoten C fließen. Wenn für diese Schaltung CF_{i,j} alle Fuseelemente abgetrennt sind, bei denen die zugehörigen Spalten-Adressen log. "1" sind, steigt der Knoten C auf hohes Potential. Dadurch wird der N-Kanal-Transistor N3 eingeschaltet. Dieser Transistor ist so dimensioniert, daß die Leitung RDNⱼ der betreffenden Einheit Eⱼ auf ein niedriges Potential nahe VSS entladen wird, obwohl die P-Kanal-Transistoren PE1 und PE2 anfangs noch leitend sind. Mit einem niedrigen Potential auf dieser Leitung wird der Transistor P6 der Schaltung CF_{i,j} eingeschaltet und der Ausgang des Inverters IE im Zustand log. "1" geschaltet. Der Rückhalte-Transistor PE2 wird dadurch nicht leitend. Das Potential von RDNⱼ kann weiter sinken. Mit einer gewissen Verzögerung, nachdem die Spalten-Adressen stabil geworden sind, oder nachdem das Freigabe-Signal FR auf hohes Potential gestiegen ist, wird das Steuersignal ATDN log. "1". Nun ist auch der Transistor PE1 ausgeschaltet und die Leitung RDNⱼ sinkt auf dem niedrigen Potential VSS (log. "0"). Obwohl jetzt auch P5 ausgeschaltet ist, bleibt der Knoten C durch die eingeschalteten Transistoren P4 und P6 log. "1". In diesem Zustand fließt im Gegensatz zur Lösung von Figur 5 kein Querstrom in der Schaltung CF_{i,j}.

Sobald der Ausgang RDⱼ des Inverters IE den Zustand log. "1" annimmt, wird ferner der entsprechende N-Kanal-Transistor Ndⱼ des Gatters DNOR leitend. Das Potential des Knotens D sinkt ebenfalls soweit, daß unabhängig vom Freigabe-Signal FR das Signal CFR log. "0" wird. Der Spalten-Dekoder wird damit verriegelt. Mit der steigenden Flanke von FR dagegen wird die entsprechende redundante Auswahl-leitung RCSLⱼ aktiv. Selbstverständlich werden für die jeweils aktive Schaltung CF_{i,j} der Einheiten Eⱼ verschiedene Spalten-Adressen programmiert, so daß nur eine der Leitungen RCSLⱼ auf einmal selektiert wird. Der beschriebene Zustand bleibt solange erhalten, bis mit einer steigenden /CAS-Flanke ATDN erneut log. "0" wird und neue Spalten-Adressen angenommen werden, oder bis mit der steigenden /RAS-Flanke die Ruhepause eingeleitet wird.

Schließlich wird die Funktion für den Fall erklärt, daß bei der aktiven Schaltung CF_{i,j} einer Einheit Eⱼ die anliegenden Spalten-Adressen nicht programmiert worden sind (in Figur 7 nicht dargestellt). Wenn mindestens bei einem N-Kanaltransistor mit nicht abgetrenntem Fuseelement die Spalten-Adresse log. "1" ist, wird der Knoten C durch diese leitende Verbindung auf so niedrigem Potential gehalten, daß der N-Kanal-Transistor N3 sperrt. Da alle anderen Schaltungen der Einheit Eⱼ inaktiv sind (C gleich log. "0", N3 gesperrt), wird die entsprechende Leitung RDNⱼ durch die eingeschalteten Transistoren PE1 und PE2 (ATDN gleich log. "0") log. "1" bleiben, oder bei einem Adreßwechsel auf hohes Potential geladen. Der Ausgang RDⱼ des Inverters IE ist dadurch log. "0" und der entsprechende N-Kanal-Transistor von DNOR ausgeschaltet. Unabhängig von FR ist die redundante Auswahlleitung RCSLⱼ (log. "0"). Dieser Zustand bleibt auch nach der steigenden ATDN-Flanke durch Spalten-Adressen selbst erhalten. In der Schaltung CF_{i,j} fließt dann kein Querstrom. Falls die programmierten Spalten-Adressen bei keiner Schaltung CF_{i,j} der aktiven Einheiten Eⱼ mit den anliegenden Spalten-Adressen übereinstimmen, sind alle Leitungen RD_{1..4} log. "0" und alle Transistoren ND_{1..4} ausgeschaltet. Wie vorher schon erklärt, wird dann der Spalten-Dekoder durch CFR="1" mit FR freigegeben.

Hauptvorteil der in Figur 4 und Figur 6 gezeigten Lösung ist die bessere Ausnutzung der Kodierungselemente bei geringem Platzbedarf. Ein Vorteil der in Figur 6 gezeigten Schaltung ist die Reduktion des Stromverbrauchs um ca. 70% gegenüber einer konventionellen Lösung durch die Verwendung des Taktes ATDN. Auf die Erzeugung dieses Signals, das mit dem Freigabe-Signal FR gekoppelt ist und im sogenannten "Fast-Page-Mode" bei dem Wechsel der Spalten-Adressen eine Rolle spielt, wird jedoch nicht näher eingegangen, weil dies nicht Bestandteil der Erfindung ist. Ein weiterer Vorteil dieser Schaltung bei konkreten Implementierungen ist die Verwendung von nur einer Leitung RDNⱼ mit Pull-Down-Transistoren N3 in den Einheiten Eⱼ.

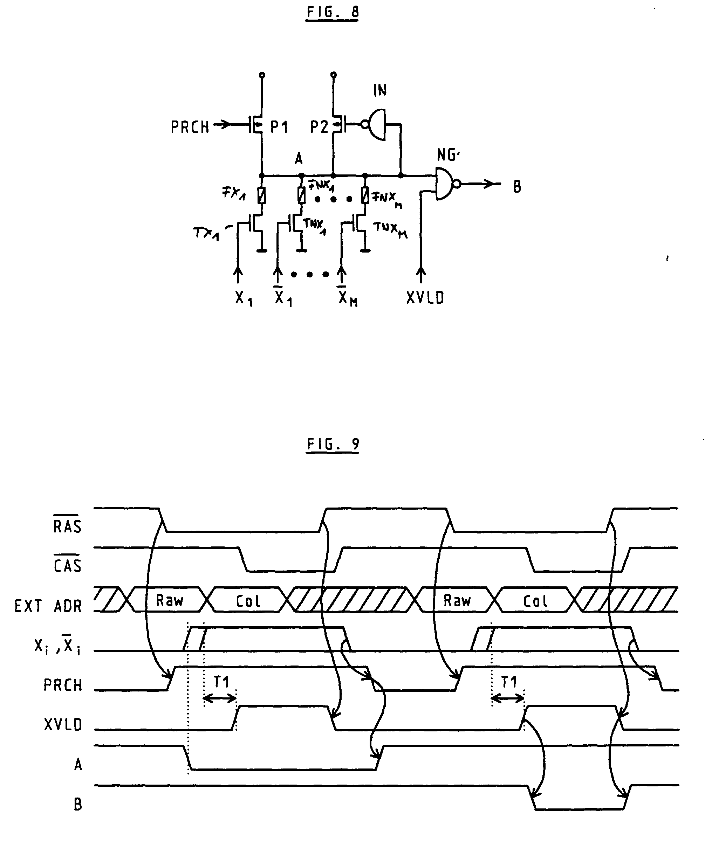

In Figur 8 ist für die Schaltung CF eine Variante der Blockkodierung gezeigt. Diese Kodierschaltung hat den Vorteil, daß während der Selektion kein Querstrom fließt. Dafür wird ein zusätzliches NAND-Gatter benötigt. Die Schaltung besteht aus zwei P-Kanal-Transistoren P1 und P2, aus einem Inverter IN, aus einem NAND-Gatter NG und aus denselben N-Kanal-Transistoren TX_{1...}TX_{M} mit Fuseelementen TX_{1...}FNX_{M} wie bei der Figur 6. Die Transistoren P1 und P2 sind zwischen dem hohen Potential VDD und dem Knoten A geschaltet. Das Signal PRCH und der Ausgang des Inverters IN sind an dem Gate von P1 bzw. von P2 geführt. Der Eingang vom Inverter IN, ein erster Eingang des NAND-Gatters NG und die parallel geschalteten Kodierungselemente sind an dem Knoten A angeschlossen. Das Signal XVLD ist am zweiten Eingang von NG geführt, dessen Ausgang das zuvor erwähnte Signal B ist.

Figur 9 zeigt ein Zeitdiagramm der verwendeten Signale zur Erläuterung der Funktion dieser Schaltung. Während der Ruhepause (/RAS="1") sind die Signale PRCH, XVLD und die Blockadressen Xᵢ, /Xᵢ, i=1..M log. "0". In diesem Zustand sind alle N-Kanal-Transistoren gesperrt und der P-Kanal-Transistor P1 leitend. Der Knoten A ist demzufolge log. "1" und der Inverter-Ausgang log. "0". Dadurch ist der Transistor P2 ebenfalls leitend. Der Ausgang B des NAND-Gatters NG ist log. "1", weil XVLD den Zustand log. "0" ausweist. Wie bereits erklärt, wird damit der Spalten-Kodierungsteil deaktiviert.

Bei einem Schreib- oder Lese-Zyklus wird das Signal PRCH nach der fallenden /RAS-Flanke log. "1". Der Zustand log. "1" des Knotens A bleibt durch den eingeschalteten Transistor P2 erhalten. Nachdem die Reihen-Adressen gespeichert sind, bleibt der Knoten A log. "1" im Falle einer Blockselektion, weil die Fuseelemente mit Blockadressen im Zustand log. "1" getrennt sind. Im anderen Falle wird er durch eine leitende Verbindung nach VSS entladen und der Inverter schaltet den P-Kanal-Transistor P2 aus. erst mit einer Verzögerung T1, nachdem die Blockadressen stabil geworden sind, steigt der Pegel vom Signal XVLD. Dadurch wird bei einer Blockselektion der Ausgang B log. "0" und die nachfolgende Schaltung wird wie bei der Figur 6 eingeschaltet. Wenn die anliegenden Blockadressen nicht programmiert sind, bleibt das Signal B log. "1".

Am Ende eines Zyklus fällt XVLD mit der steigenden /RAS-Flanke auf niedriges Potential. Das Signal B wird log. "1" und die Spaltenkodierung der Schaltung CF wird ausgeschaltet. Die Blockadressen weren dann, gefolgt vom Signal PRCH, zurückgesetzt (log. "0"). Der Knoten A steigt dadurch wieder auf hohes Potential. Vorteil der Schaltung ist, daß kein Querstrom durch den Transistor Pl fließt, wenn die anliegenden Blockadressen nicht programmiert worden sind.

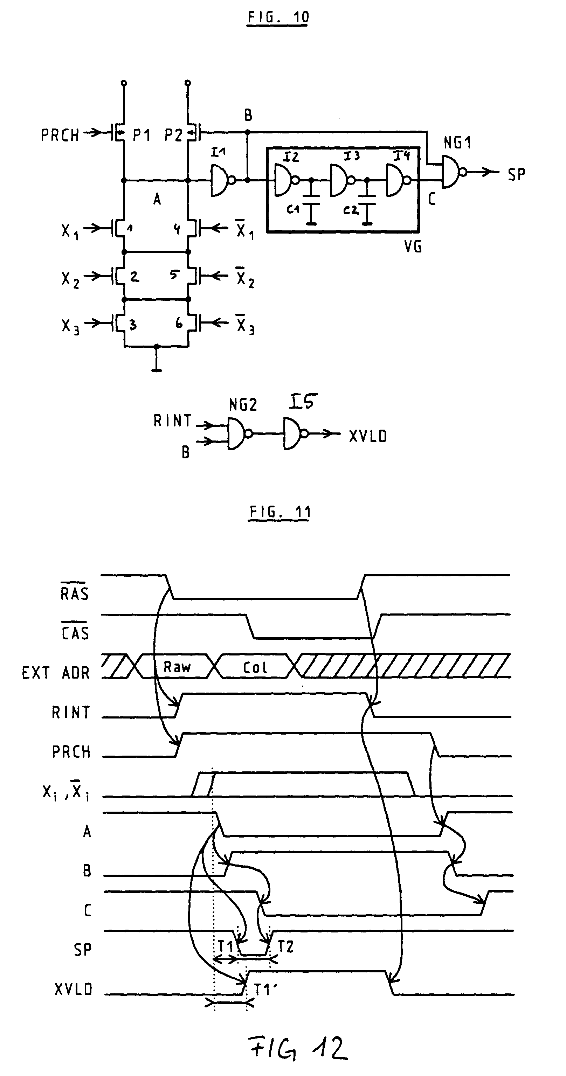

Figur 10 zeigt eine Schaltung zur Erzeugung des Setzpulses SP von Figur 6 und eine Zusatz-Schaltung zur Bildung des Signals XVLD von Figur 8. Die erste Schaltung besteht aus zwei P-Kanal-Transistoren P1 und P2, aus einem Inverter I1, aus einem invertierenden Verzögerungsglied VG, aus einem NAND-Gatter NG1 und bei diesem Beispiel aus drei Paaren von N-Kanal-Transistoren 1...6. Die Transistoren P1 und P2 sind zwischen VDD und dem Knoten A parallel geschaltet. Das Signal PRCH ist an dem Gate von P1 angeschlossen. Die paarweise parallel geschalteten N-Kanal-Transistoren 1...6 mit Gate-Signalen Xᵢ bzw. /Xᵢ, i=1..3, sind zwischen dem Knoten A und dem niedrigen Potential VSS seriell angeordnet. Der Knoten A ist der Eingang des Inverters I1. Der Ausgang B dieses Inverters I1 ist an dem Gate von P2, an einem ersten Eingang des NAND-Gatters NG1 und an dem Eingang des Verzögerungsgliedes VG angeschlossen. Der Ausgang C dieses Gliedes ist der zweite Eingang von NG1 mit Ausgangs-Signal SP. Das Verzögerungsglied VG besteht aus einer ungeraden Anzahl von hintereinander geschalteten Invertern I2, I3, I4 mit Verzögerungskapazitäten C1, C2 in bekannter Schaltungsweise. Bei diesem Beispiel sind drei Inverter und zwei Kapazitäten gezeigt.

Bei der in Figur 11 gezeigten Schaltung zur Erzeugung von XVLD werden NG1 und VG durch ein NAND-Gatter NG2 und einen nachgeschalteten Inverter 15 mit Ausgangssignal XVLD ersetzt. Die Eingänge von NG2 sind die Signale RINT und B.

Ein Zeitdiagramm der aufgeführten Signale ist in Figur 12 dargestellt. Das Signal RINT, das im Speicher anderweitig Verwendung findet, ist ein bezüglich dem externen /RAS-Signal invertierter Takt. In der Ruhepause (/RAS="1") sind RINT, PRCH und alle Blockadressen Xᵢ bzw. /Xᵢ log. "0". Die N-Kanal-Transistoren zwischen dem Knoten A und VSS sind in diesem Zustand alle gesperrt, P1 dagegen leitend. Dadurch liegt A auf hohem und B auf niedrigem Potential. Der Transistor P2 ist eingeschaltet. Mit dem Signal B im Zustand log. "0" sind die Ausgänge SP und C von NG1 und VG log. "1". Das Signal XVLD ist dagegen log. "0". Mit der fallenden /RAS-Flanke steigt PRCH auf hohes Potential. Der Zustand log. "1" von A bleibt zunächst durch den eingeschalteten Transistor P2 erhalten, obwohl P1 jetzt sperrt. Nachdem die externen Reihenadressen gespeichert sind, wird bei jedem Paar von Signalen Xᵢ und /Xᵢ je nach Adreßkombination das eine oder das andere Signal aktiv log. "1". Sobald alle Blockadressen mit diesem logischen Zustand anliegen, sinkt der Knoten A über den sich daraus ergebenden leitenden Pfad nach VSS auf niedriges Potential. Dadurch wird der Ausgang B des Inverters IV log. "1" und der Transistor P2 ausgeschaltet. Da nun P1 und P2 gesperrt sind, fließt kein Querstrom nach VSS. Dieser Zustand bleibt durch die Blockadressen Xᵢ und /Xᵢ selbst erhalten. Mit einer gewissen Verzögerung T1, nachdem die langsamste Blockadresse Xᵢ oder /Xᵢ log. "1" geworden ist, wird das Signal SP log. "0", weil die Signale B und C beide auf hohem Potential liegen. Die steigende Flanke von B wird aber nach einer Verzögerung T2 durch das Verzögerungsglied VG invertiert. Das Signal C wird also nach dieser Zeit log. "0" und der Ausgang SP des NAND-Gatters NG1 dadurch wieder log. "1". Bei der Zusatzschaltung zur Erzeugung von XVLD wird dieses Signal nach einer Verzögerung T1', nachdem alle Blockadressen stabil geworden sind, durch die steigende Flanke von B log. "1", weil das Signal RINT in diesem Zeitbereich log. "1" ist.

Am Ende eines aktiven Zyklus werden mit der steigenden /RAS-Flanke die Signale RINT, Xᵢ, /Xᵢ und PRCH nacheinander log. "0". Die leitende Verbindung zwischen dem Knoten A und VSS wird aufgehoben. Der Knoten A wird mit PRCH="0" über P1 log. "1" und das Signal B log. "0". Der Ausgang C von VG wird mit Verzögerung log. "1". Da nach dem Setzpuls SP entweder C oder B log. "0" sind, bleibt auch SP log. "1". Das Signal XVLD wird kurz nach der steigenden /RAS-Flanke durch RINT="0" ausgeschaltet.

## Patentansprüche

1. Spalten-Redundanz-Schaltungsanordnung für einen Speicher mit a Speicherblöcken (BK_{1...N}) mit in x Zeilen und y Spalten angeordneten Speicherzellen, mit redundanten Speicherzellen die in b Zeilen und c Spalten angeordnet sind, mit einem Spaltendekoder (CDEC), mit c redundanten Spaltendekodern (RCD_{1...n}), wobei jeder redundante Spaltendekoder (RCD_{1...4}) jeweils einer der c redundanten Spalten jedes Speicherblocks (BK_{1...N}) zugeordnet ist, mit d Kodierungselementen (CF_{1,1...} CF_{P,4}),
wobei jedes der d Kodierungselemente (CF_{1,1...} CF_{P,4}) Adreßdekodiermittel enthält, zum Zuordnen der Kodierungselemente zu einem beliebigen der Speicherblöcke (BK_{1...N}), die getrennte Mittel zum Dekodieren der Speicherblockadresse (X₁ - X_{M}) und der Spaltenadresse (Y₁-Y_{K}) enthalten,
**dadurch gekennzeichnet,**
daß die Mittel zum Dekodieren der Blockadresse in Reihe zu den Mitteln zum Dekodieren der Spaltenadresse geschaltet sind,
so daß ein Verbinden (P4) der Mittel zum Dekodieren der Spaltenadresse mit einem Versorgungspotential (VDD) erst erfolgt, wenn die Mittel zum Dekodieren der Blockadresse das Anliegen einer programmierten Blockadresse registriert haben.

2. Spalten-Redundanz-Schaltungsanordnung gemäß Anspruch 1,
**dadurch gekennzeichnet**, daß die Anzahl der Kodierungselemente (CF_{1,1...} CF_{P,4}) d kleiner dem Produkt der Anzahl von Speicherblöcken a (BK_{1...N}) und der Anzahl von redundanten Spaltendekodern (RCD_{1...4}) ist.

3. Spalten-Redundanz-Schaltungsanordnung gemäß Anspruch 1 oder 2,
**dadurch gekennzeichnet**, daß die Kodierungselemente (CF_{1,1...} CF_{P,4}) in c Gruppen aufgeteilt sind, das ein NOR-Gatter (NOR) mit c Eingängen vorgesehen ist, daß die Eingänge des NOR-Gatters (NOR) mit den Ausgängen der Kodierungselemente (CF_{1,1...} CF_{P,4})verbunden sind, daß der Ausgang des NOR-Gatters (NOR) mit einem Aktiviereingang des Spaltedekoders (CDEC) verbunden ist.

4. Spalten-Redundanz-Schaltungsanordnung nach einem der Ansprüche 1 bis 3,
**dadurch gekennzeichnet**, daß ein Speicherblock (BK_{1...4}) eine Vielzahl von Einzelspeicherblöcken umfaßt und daß redundante Spaltenleitungen in allen Einzelspeicherblöcken gleichzeitig die jeweiligen zu ersetzenden Spaltenleitungen ersetzen können.

5. Spalten-Redundanz-Schaltungsanordnung nach einem der vorstehenden Ansprüche,
**dadurch gekennzeichnet**, daß die Mittel zum Dekodieren der Speicherblockadresse bzw. der Spaltenadresse eine Vielzahl von parallel geschalteten Reihenschaltungen von auftrennbaren Sicherungselementen (FX_{1...} FNX_{M}; FY_{y...} FNY_{K}) und der Laststrecke von Feldeffekttransistoren (Fx_{1...} TNX_{M}; TY_{1...} TNY_{M}) aufweisen, die zwischen einem Knotenpunkt (A;C) und Masse geschaltet sind, wobei den Steuereingängen der Feldeffekttransistoren die Adreß-Signale zugeführt werden, mit einer Haltestufe (IV, P3; N3, P6) deren Eingangsanschluß mit dem Knotenpunkt (A;C) verbunden ist und an deren Ausgangsanschluß ein erstes Dekodiersignal abgreifbar ist, einer Aktivierstufe (P1, P2, N1; P4, P5, N2), deren Ausgangssignal dem Knotenpunkt (A, C) beaufschlagt wird.

6. Spalten-Redundanz-Schaltungsanordnung nach Anspruch 5,
**dadurch gekennzeichnet**, daß die Aktivierstufe zwei Feldeffekttransistoren (P1, P2; P4, P5) von einem ersten Leitungstyp und einem Feldeffekttransistor (N1; N2) eines zweiten Leitungstyps enthalten, deren Laststrecken in Reihe zwischen einem Versorgungsspannungspotential (VDD) und Masse geschaltet sind, wobei die Steueranschlüsse des an Masse angeschlossenen Feldeffekttransistors (N1; N2) vom zweiten Leitungstyp und der Steueranschluß des mit dem Versorgungspotential verbundenen Feldeffekttransistors (P1; P4) des ersten Typs miteinander verbunden sind und ein erstes Steuersignal (EN; B) zugeführt wird, dem Steueranschluß des zweiten Feldeffekttransistors (P2; P5) vom ersten Leistungstyp ein weiteres Steuersignal (SP; ATDN) zugeführt wird und am Knotenpunkt der Reihenschaltung der Laststrecken des zweiten Feldeffekttransistors (P2; P5) vom ersten Leitungstyp und des Feldeffekttransistors (N1; N2) vom zweiten Leitungstyp das Ausgangssignal abgegriffen werden kann.

## Claims

1. Column redundancy circuit arrangement for a memory having a memory blocks (BK_{1...N}) having memory cells arranged in x rows and y columns, having redundant memory cells arranged in b rows and c columns, having a column decoder (CDEC), having c redundant column decoders (RCD_{1.....N}), each redundant column decoder (RCD_{1.....4}) respectively being assigned to one of the c redundant columns of each memory block (BK_{1.....N}), having d coding elements (CF_{1, 1...}CF_{P,4}),
each of the d coding elements (CF₁, _{1...}CF_{P,4}) containing address decoding means, for assigning the coding elements to an arbitrary one of the memory blocks (BK_{1.....N}), which contain separate means for decoding the memory block address (x₁-x_{M}) and the column address (y₁-y_{K}),
characterized
in that the means for decoding the block address are connected in series with the means for decoding the column address,
with the result that connection (P4) of the means for decoding the column address to a supply potential (VDD) takes place only when the means for decoding the block address have registered the presence of a programmed block address.

2. Column redundancy circuit arrangement according to Claim 1,
characterized in that the number of coding elements (CF₁, _{1...}CF_{P,4}) d is less than the product of the number of memory blocks a (BK_{1......N}) and the number of redundant column decoders (RCD_{1.....4}).

3. Column redundancy circuit arrangement according to Claim 1 or 2,
characterized in that the coding elements (CF_{1, 1...}CF_{P,4}) are divided into c groups, in that a NOR gate (NOR) having c inputs is provided, in that the inputs of the NOR gate (NOR) are connected to the outputs of the coding elements (CF₁, _{1...}CF_{P,4}), in that the output of the NOR gate (NOR) is connected to an activation input of the column decoder (CDEC).

4. Column redundancy circuit arrangement according to one of Claims 1 to 3,
characterized in that a memory block (BK_{1....4}), comprises a multiplicity of individual memory blocks, and in that it is possible for redundant column lines in all the individual memory blocks simultaneously to replace the respective column lines to be replaced.

5. Column redundancy circuit arrangement according to one of the preceding claims,
characterized in that the means for decoding the memory block address and respectively the column address have a multiplicity of parallel-connected series circuits of fuse elements (FX_{1.....} FNX_{M}; FY_{y.....} FNY_{K}) and the load path of field-effect transistors (Fx_{1.....} TNX_{M}; TY_{1....} TNY_{M}), which are connected between a node (A;C) and earth, the address signals being fed to the control inputs of the field-effect transistors, having a holding stage (IV, P3; N3, P6), whose input terminal is connected to the node (A;C) and at whose output terminal a first decoding signal can be tapped off, and an activation stage (P1, P2, N1; P4, P5, N2), whose output signal is applied to the node (A,C).

6. Column redundancy circuit arrangement according to Claim 5,
characterized in that the activation stage contains two field-effect transistors (P1, P2; P4, P5) of a first conduction type and one field-effect transistor (N1; N2) of a second conduction type, whose load paths are connected in series between a supply voltage potential (VDD) and earth, in which case the control terminals of the field-effect transistor (N1; N2) of the second conduction type which is connected to earth and the control terminal of the field-effect transistor (P1; P4) of the first type which is connected to the supply potential are connected to one another and a first control signal (EN; B) is fed in, a further control signal (SP; ATDN) is fed to the control terminal of the second field-effect transistor (P2; P5) of the first conduction type and the output signal can be tapped off at the node of the series circuit formed by the load paths of the second field-effect transistor (P2; P5) of the first conduction type and of the field-effect transistor (N1; N2) of the second conduction type.

## Revendications

1. Agencement de circuit à redondance de colonnes pour une mémoire comptant a blocs de mémoire (BK_{1...N}) avec des cellules de mémoire disposées en x lignes et y colonnes, avec des cellules de mémoire redondantes qui sont disposées en b lignes et c colonnes, avec un décodeur de colonnes (CDEC), avec c décodeurs de colonnes redondantes (RCD_{1...n}), chaque décodeur de colonnes redondantes (RCD_{1...4}) étant associé à chaque fois à l'une des c colonnes redondantes de chaque bloc de mémoire (BK_{1...N}), avec d éléments de codage (CF_{1,1...} CF_{P,4}),
chacun des d éléments de codage (CF_{1,1...} CF_{P,4}) comprenant des moyens de décodage d'adresse pour conjuguer des éléments de codage à l'un quelconque des blocs de mémoire (BK_{1...N}), qui comprennent des moyens séparés pour le codage des adresses des blocs de mémoire (X₁-X_{M}) et des adresses de colonne (Y₁-Y_{K}).
caractérisé en ce que les moyens de décodage de l'adresse de bloc sont branchés en série par rapport au moyen de décodage de l'adresse de colonne, de telle sorte qu'une liaison (P4) des moyens de décodage de l'adresse de colonne avec un potentiel d'alimentation (VDD) ne s'effectue que si les moyens de décodage de l'adresse de bloc ont enregistré l'application d'une adresse de bloc programmée.

2. Agencement de circuit à redondance de colonnes selon la revendication 1, caractérisé en ce que le nombre des éléments de codage (CF_{1,1...}CF_{P,4}) d est plus petit que le produit du nombre des adresses de mémoire a (BK_{1...N}) et que le nombre de décodeurs de colonnes redondantes (RCD_{1...4}).

3. Agencement de circuit à redondance de colonnes selon la revendication 1 ou 2, caractérisé en ce que les éléments de codage (CF_{1,1...}CF_{P,4}) sont répartis en c groupes, en ce qu'une grille NON-OU (NON-OU) est dotée de c entrées, en ce que les entrées de la grille NON-OU (NON-OU) sont reliées aux sorties des éléments de codage (CF_{1...} CF_{P,4}), et en ce que la sortie de la grille NON-OU (NON-OU) est reliée à une entrée d'activation du décodeur de colonnes (CDEC).

4. Agencement de circuit à redondance de colonnes selon l'une des revendications 1 à 3, caractérisé en ce qu'un bloc de mémoire (BK_{1...4}) comprend une pluralité de blocs de mémoire individuels et en ce que des conducteurs de colonnes redondantes peuvent remplacer en même temps dans tous les blocs de mémoire individuels les conducteurs de colonnes qui doivent à chaque fois être remplacés.

5. Agencement de circuit à redondance de colonnes selon l'une des revendications précédentes, caractérisé en ce que les moyens de décodage de l'adresse de blocs de mémoire resp. de l'adresse de colonnes présentent une pluralité de circuits séries, branchés en parallèle, d'éléments de protection séparables (FX_{1...}FNX_{M}; FY_{y...}FNY_{K}) et le parcours de charge de transistor à effet de champ (FX_{1...} TNX_{M}; TY_{1...} TNY_{N}) qui sont branchés entre un point de noeud (A;C) et la masse, tandis que les signaux d'adresse sont appliqués aux entrées de commande des transistors à effet de champ, avec un étage de maintien (IV, P3; N3, P6) dont le raccordement d'entrée est relié au point de noeud (A; C) et sur le raccordement de sortie desquels un premier signal de décodage peut être extrait, et un étage d'activation (P1, P2, N1; P4, P5, N2) dont le signal de sortie est appliqué sur le point de noeud (A, C).

6. Agencement de circuit à redondance de colonnes selon la revendication 5, caractérisé en ce que l'étage d'activation contient deux transistors à effet de champ (P1, P2; P4, P5) d'un premier type de conductivité et un transistor à effet de champ (N1; N2) d'un deuxième type de conductivité, dont les parcours de charge sont raccordés en série entre un potentiel de tension d'alimentation (VDD) et la masse, tandis que les raccordements de commande du transistor à effet de champ (N1; N2) raccordé à la masse du deuxième type de conductivité et le raccordement de commande du transistor à effet de champ (P1; P4) relié au potentiel d'alimentation, du premier type, sont reliés l'un à l'autre, et un premier signal de commande (EN; B) est appliqué, qu'au deuxième raccordement de commande du deuxième transistor à effet de champ (P2; P5) du premier type de conductivité est amené un autre signal de commande (SP; ATDN), et que le signal de sortie peut être repris sur le point de noeud du circuit série des parcours de charge du deuxième transistor à effet de champ (P2; P5) du premier type de conductivité et du transistor à effet de champ (N1; N2) du deuxième type de conductivité.
